# EUROPEAN PATENT APPLICATION

(11) **EP 4 803 717 A1**
(43) Date of publication of application: **09.09.2026**
(21) Application number: 25161888.0
(22) Date of filing: 05.03.2025
(51) Int. Cl.: E04D 1/34, G06F 30/13

(54) **METHOD FOR OPTIMIZING THE ANCHORING OF TILES**

(71) Applicant: Ubbink B.V., 6984 AA Doesburg (NL)
(72) Inventor: VAN DER HAM, Johannes Hubertus Petrus, 6984 AA Doesburg (NL)
(74) Representative: van Dam, Vincent

(57) **Abstract**

The present invention relates to a method for optimizing the anchoring of tiles to an outer surface of a building, wherein a single digital and/or physical image is generated containing indications on the basis of which said tiles can be mounted on surface portions of the building and, if necessary, anchored according to the requirements associated with respective designated zones displayed in said image. The invention also relates to a computer-readable medium programmed for generating said single image in accordance with said method.

## Description

The present invention relates to a method for optimizing the anchoring of tiles to an outer surface of a building, wherein a single digital and/or physical image is generated containing indications on the basis of which said tiles can be mounted on surface portions of the building and, if necessary, anchored according to the requirements associated with respective designated zones displayed in said image. The invention also relates to a computer-readable medium programmed for generating said single image in accordance with said method.

It is important that tiles are securely installed on outer surfaces of a building, in particular a roof of a building but also, when applicable, the vertical parts of a building, for instance if the building comprises one or more tiled facades.

Secure installation and the use of suitable materials ensures durability and safety.

The increasing internationalization on construction sites and the associated problems with language differences sometimes cause confusion on the construction site and risks of construction errors which may adversely affect the durability and safety of roof and facade constructions.

### Description of the invention

The present invention aims to provide a method that ensures secure and durable installation of tiles on surfaces of buildings and which can be understood and implemented by any worker, regardless of the technical background and language skills.

In order to achieve this, the present invention in one aspect relates to a method for optimizing the anchoring of tiles to an outer surface of a building, wherein said outer surface comprise one or more sloping and/or vertical surface portions, and wherein the method comprises: wherein the method comprises: determining a distribution of wind load with regard to each surface portion to be tiled; on the basis of this determination, dividing each surface portion to be tiled into one or more zones, each with a determined range of wind load; correlating the wind load per determined range to a predetermined required degree of anchoring of the tiles; wherein, on the basis of this correlation, each zone of said one or more zones is designated as a designated zone with predetermined tile anchoring requirements; and displaying said surface with said one or more sloped and/or vertical surface portions and said designated zones therein in a single digital and/or physical image and wherein each designated zone displayed in said image contains an indication on the basis of which said tiles can be mounted on said surface portions and, if necessary, anchored according to the requirements associated with the respective designated zones displayed in said image.

The image that is generated provides a fool-proof overview for all involved parties (contractor, roofer, quality assurance provider), making the process of installing a roof and/or facade of a building much easier while at the same time ensuring safety and durability.

The single image in the context of the present invention is to be understood as a full overview of a building area to be tiled. Such a building area is in general a roof part of the building. Said full overview may comprise one or more parts represented in the same overview.

The method according to the invention allows optimal use of anchoring means for tiles to an outer surface of a building, by providing clear indications of the extent of anchoring that is to be used for designated areas of surface portions of a building. This avoids excessive use of materials and at the same time ensures that all requirements for anchoring are met in a way that can be implemented and understood by any party involved with constructing the building and in particular the roof.

The invention is applicable to any building structure and in particular any roof structure to be covered with tiles, including but not limited to roofs selected from a pent roof, a mansard roof, a hipped roof, a gable roof, a tent roof, a T-roof, a pitched roof and a cross roof. In the context of the invention said outer surface of said building is therefore suitably a roof of a building and wherein sloped surface portions are sloped roof parts.

The outer surfaces may also comprise one or more vertical surface portions, for instance of a building facade. A vertical surface portion may therefore suitably be a facade portion. A facade portion in the context of the present invention may be any sidewall surface portion of a building, such a front exterior part, back exterior part or any side exterior part. The invention is also applicable to buildings with vertical roof parts to be covered with tiles.

The method of the invention comprises determining a distribution of wind load with regard to each surface portion to be tiled.

This can be done by means of methods known in the art. The wind load can be defined as the force of air particles hitting a surface on a specific structure, for instance a building. Wind load determination methods are commonly known in the art and calculate the wind load on a surface taking into account wind velocity and air density. The wind load also depends on the effective surface area of a structure. The effective surface is the surface orthogonal to the wind direction. Assuming that wind is always parallel to the horizon, the effective surface may be calculated from the total surface and the angle. For example, a surface at 90° to the ground (i.e. a vertical surface or a facade) is exposed to much more wind load than a sloped roof, such as a roof with a 45° roof slope, even if the wind speed and surface area are the same. Taking into account these factors, in a simple representation a wind load can be determined for instance as follows: wind load = dynamic pressure × effective surface = dynamic pressure × total surface × sin(angle), wherein the dynamic pressure = 0.5 × air density × wind speed².

In a suitable embodiment the wind load is determined in accordance with national or international standards, for instance in accordance with Dutch standards NEN-EN 1991-1-4+A1+C2/NB:2020 and NPR 6708:2019.

NEN-EN 1991-1-4+A1+C2/NB:2020 (downloadable from www.nen.nl, the contents of which should be considered as incorporated herein) lays down the values applicable to the Netherlands for nationally established parameters. It serves to demonstrate that a construction work achieves the level of structural safety as required by the Dutch building regulations.

NPR 6708:2019 is a further elaboration of earlier standard NEN 6707 (both downloadable from www.nen.nl, the contents of which should be considered as incorporated herein) and provides methods for testing whether the resistance of a roof covering to blowing off is not exceeded.

Upon determination of the wind load of each surface portion to be tiled each surface portion to be tiled is divided into one or more zones, each with a determined range of wind load. The wind load per determined range is then correlated to a predetermined required degree of anchoring of the tiles. This can be based on applicable standards and requirements, including national and international standards, such as the abovementioned Dutch standards NEN-EN 1991-1-4+A1+C2/NB:2020 and NPR 6708:2019.

Based on this correlation, each zone of said one or more zones is designated as a designated zone with the abovementioned predetermined tile anchoring requirements.

When tiles are anchored, it is preferable that roof tiles are anchored with tile hooks as standard anchorage means. Such tile hooks are preferably made of stainless steel. Each type roof tile may have its own specific hook. The way in which the roof tiles are anchored depends not only on the wind load of the roof, but also on the roof tile model. Additional anchorage measures may include but are not limited to screws, bolts etc.

In a suitable and practical embodiment designated zones may be chosen from at least:
- a zone A within which tiles do not have to be anchored;
- a zone B within which a part of the tiles must be anchored;
- a zone C within which each tile must be anchored;
- a zone D where additional anchoring is required in addition to standard anchorage measures.

Herein, in zone A tiles may be placed on the supporting structure of the roof without further securing provisions. This zone is a zone A wherein the determined wind load is low or even absent.

In zone B tiles may be placed on the supporting structure of the roof tiles with standard anchoring provisions for a part of the tiles in that zone. A common way of such partial anchoring is so-called checkerboard anchoring. This involves anchoring roof tiles in an alternate fashion. This means that every second roof tile is secured, for instance with a tile hook, while the other roof tiles rest on top of it. This method is often used for portions exposed to mild wind conditions, but in general higher than in zone A.

Zone C may represent a zone exposed to a higher wind load than zone B. Here each tile must be anchored, for instance with suitable tile hooks as mentioned above. For instance, for roof surfaces with a pitch of 75 - 80°, the requirement may be set that all roof tiles and accessories must be fully anchored. This means that all roof tiles must be anchored with an associated tile hook.

Tiles in zone D need additional anchoring in addition to standard anchorage measures such as the abovementioned tile hooks. Zone D is a zone which may be exposed to an even higher wind load than zone C or may be zone at a position that requires special provisions in view of its specific position, for instance on the corners of a roof or close to structures such as chimneys. In general, also a substantially vertical surface needs additional anchoring in addition to standard anchorage measures. Roof tiles used on a roof pitch of 80 - 90° (facade cladding) must be anchored with a screw with washer and a tile hook in the side lock. For roof tiles with two waves, two screws may be used accordingly. Facade tiles may for example be mechanically fastened by means of tile hooks in the side closure and screws with washers in the head closure. The left facade tile may for instance be mechanically fastened by means of a screw with washer in the batten. If the holes required for this are not factory-made, they can be drilled during mounting. The adjacent row of roof tiles may be fully fastened with a tile hook in the side closure. Facade tiles are commonly required to be fastened with a fastener with a design value for resistance to blowing off of at least 2000 N/m².

In addition to the abovementioned zones A-D**,** any additional zone or subzone may be designated as well, and not per se based on wind load. Examples of such zones may include for instance a first row of roof tiles around roof windows, dormers, integrated solar panels, chimneys, etc. and along valley gutters and concealed gutters (e.g. at facade termination) which may suitably be secured with stainless steel screws. As another example, when using mineral wool on the construction wall, it may be desirable that all tiles are fully anchored for the width of this strip. Another example may be in the case of anchoring small sawn roof tiles to the adjacent roof tile, which can be done by using suitable roof tile adhesive (structural strength equal to the roof tile strength) in the side closures. The need for these specific provisions may also be indicated in an specific additional zones or subzones.

In accordance with the present invention therefore, the method may therefore also comprise designating zones with predetermined tile anchoring requirements based on other parameters than wind load or based on wind load in combination with such other parameters. An important parameter in this respect is the intended position of the tiles on the roof structure.

Special attention is to be taken for tiling of connection sections between surfaces with different slope or between a roof surface and another structure associated with the roof, such as the abovementioned roof windows, dormers, integrated solar panels, chimneys, etc. The requirements for these sections are not per se only based on wind load based requirements. In accordance, the method of the invention may further comprise designating connecting sections between zones as designated connecting sections (or in other words as designated connecting zones), and wherein said designated connecting sections are also displayed in said single digital and/or physical image and wherein each displayed designated connecting sections contains an indication on the basis of which said connecting sections can be constructed. These indications may for instance indicate additional anchoring provisions at a connecting bend. For instance, when using a dry self-ventilating ridge-hip construction, the ridge tiles on the ridge-hip may be indicated to be mechanically attached using the designated ridge hooks in combination with screws with washers of sufficient length. Semi-circular ridge tiles can also be anchored using screws of sufficient length with washers fitted behind the collar of the semi-circular ridge. A calculation value for attachment of 800 N/m is normally taken into account for these purposes. When using ridge tiles on the ridge-hip in mortar, indications may include that the ridge tiles is to be mechanically attached to the rider on the ridge-hip. Indications with regard to start and end ridge tiles may for instance be include the requirement to be mechanically attached using screws with washers on the top of these ridge tiles, optionally in combination with ridge hooks. Indications may also include that head shields of the beginning/end ridges must be anchored in the head of the ridge using screws with washers.

In accordance with the invention said surface with said one or more sloped and/or vertical surface portions and said designated zones, including the abovementioned designated connecting sections if applicable, therein is displayed in a single digital and/or physical image and wherein each designated zone displayed in said image contains an indication on the basis of which said tiles can be mounted on said surface portions and, if necessary, anchored according to the requirements associated with the respective designated zones displayed in said image.

With regard to the indication(s) displayed in said image it is preferred that for said designated zones said indication(s) displayed in said image comprise(s) a code associated with instructions on the basis of which said tiles can be mounted on said surface portions and, if necessary, anchored according to the requirements associated with the respective designated zones displayed in said image.

Any suitable type of code may be applicable and may depend on the wishes and requirements at the building site.

Codes may for instance include color, letter, or number codes or any combination thereof, wherein specific letters, numbers, colors or combinations thereof are associated with specific instructions with regard to mounting tiles on said surface portions and, if needed anchored. The instructions may also contain instructions with regard to the materials to be used and alternatives if a preferred material is not available.

Such instructions may be in any form, including but not limited to instructions included in a mobile app.

In a preferred embodiment said code comprises a color code wherein each color is associated with specific instructions on the basis of which said tiles can be mounted on said surface portions and, if necessary, anchored according to the requirements associated with the respective designated zones displayed in said image.

Likewise, for each displayed designated connecting section or any other section said indication(s) displayed in said image comprise(s) a code associated with instructions on the basis of which said connecting sections can be constructed. Also in this case, said code preferably comprises a color code and wherein each color is associated with specific instructions on the basis of which said connecting sections can be constructed.

The use of color codes provides a particular simple and efficient way to provide fool-proof overview of the tiling anchoring requirements for all market parties (contractor, roofer, quality assurance provider), making the process of installing a roof and/or facade of a building much easier while ensuring safety and durability.

In view of the above, the method of the invention may comprise the actual step of installing tiles on said an outer surface of a building based on the indications displayed in said single image and their respective associated instructions.

For further convenience and fool-proofness, said instructions may also contain instructions with regard to the selection for the construction materials to be used.

For the same reason, said image may be based on the visualization of rooftiles. Basing the image on the visualization of rooftiles instead of distances allows the user to simply assess the number and position of tiles without the need for performing measurements during the actual construction of the roof.

In a preferred embodiment the image is displayed on a mobile device, for instance a mobile phone using an app that can be downloaded by the parties and persons involved with the construction of the building and in particular with mounting the tiles. The image may of course also be displayed on a sheet or screen that can be presented in a construction site trailer.

In practice the method of the invention, or at least the steps of determining a distribution of wind load, dividing each surface portion to be tiled into one or more zones, correlating the wind load per determined range to a predetermined required degree of anchoring of the tiles; designating said one or more zones as a designated zone with predetermined tile anchoring requirements; and displaying said surface in a single image can be implemented on a computer using software that can be programmed by a normally skilled programmer. Further steps of the invention that are suitable for implementation on a computer may also be computer implemented. The method can therefore suitably be at least partially computer implemented.

In this respect it is also to be understood that the present invention relates to a computer-readable medium programmed for generating said single image in accordance with the method according to the invention as disclosed above.

## Claims

1. Method for optimizing the anchoring of tiles to an outer surface of a building, wherein said outer surface comprise one or more sloping and/or vertical surface portions, and
wherein the method comprises:
determining a distribution of wind load with regard to each surface portion to be tiled;
on the basis of this determination, dividing each surface portion to be tiled into one or more zones, each with a determined range of wind load;
correlating the wind load per determined range to a predetermined required degree of anchoring of the tiles;
wherein, on the basis of this correlation, each zone of said one or more zones is designated as a designated zone with predetermined tile anchoring requirements; and
displaying said surface with said one or more sloped and/or vertical surface portions and said designated zones therein in a single digital and/or physical image and wherein each designated zone displayed in said image contains an indication on the basis of which said tiles can be mounted on said surface portions and, if necessary, anchored according to the requirements associated with the respective designated zones displayed in said image.

2. Method according to claim 1, wherein said one or more zones is designated as a designated zone with predetermined tile anchoring requirements selected from at least
• a zone A within which tiles do not have to be anchored;
• a zone B within which a part of the tiles must be anchored;
• a zone C within which each tile must be anchored;
• a zone D where additional anchoring is required in addition to standard anchorage measures.

3. Method according to claim 1 or 2, wherein said outer surface of said building is a roof of a building and wherein sloped surface portions are sloped roof parts and vertical surface portions are facade portions.

4. Method according to any of the previous claims, further comprising designating connecting sections between zones as designated connecting sections, and wherein said designated connecting sections are also displayed in said single digital and/or physical image and wherein each displayed designated connecting section contains an indication on the basis of which said connecting section can be constructed.

5. Method according to any of the previous claims, wherein for said designated zones said indication(s) displayed in said image comprise(s) a code associated with instructions on the basis of which said tiles can be mounted on said surface portions and, if necessary, anchored according to the requirements associated with the respective designated zones displayed in said image.

6. Method according to claim 5, wherein said code comprises a color code and wherein each color is associated with specific instructions on the basis of which said tiles can be mounted on said surface portions and, if necessary, anchored according to the requirements associated with the respective designated zones displayed in said image.

7. Method according to any of the previous claims, wherein for each displayed designated connecting section said indication(s) displayed in said image comprise(s) a code associated with instructions on the basis of which said connecting sections can be constructed.

8. Method according to claim 7, wherein said code comprises a color code and wherein each color is associated with specific instructions on the basis of which said connecting sections can be constructed.

9. Method according to any of the claims 5 to 8, wherein said instructions also contain instructions with regard to the selection for the construction materials to be used.

10. Method according to any of the previous claims, wherein said image is based on the visualization of rooftiles.

11. Method according to any of the previous claims, wherein said image is displayed on a mobile device.

12. Method according to any of the claims 1 to 11, wherein said outer surface is a roof selected from the group of pent roof, mansard roof, hipped roof, gable roof, tent roof, T-roof, pitched roof and cross roof.

13. Method according to any of the previous claims, wherein the method is computer implemented.

14. Method according to any of the previous claims, which further comprises installing tiles on said an outer surface of a building based on the indications displayed in said single image.

15. Computer-readable medium programmed for generating said single image in accordance with the method according to any of previous claims.
